# Europäisches Patentamt

# European Patent Office

# Office européen des brevets

(11) Veröffentlichungsnummer: **0 016 860**
**A1**

## EUROPÄISCHE PATENTANMELDUNG

(21) Anmeldenummer: **79104830.9**

(22) Anmeldetag: **01.12.79**

(51) Int. Cl.³: **H 01 L 27/02**, H 01 L 21/74 // H03K19/08

(30) Priorität: **22.12.78 DE 2855768**

(43) Veröffentlichungstag der Anmeldung: **15.10.80** Patentblatt **80/21**

(84) Benannte Vertragsstaaten: **DE FR GB IT**

(71) Anmelder: **Deutsche ITT Industries GmbH, Hans-Bunte-Strasse 19 Postfach 840, D-7800 Feiburg (DE)**

(72) Erfinder: **Wirth, Anton, Lichtenbergstrasse 5, D-7800 Freiburg (DE)**
Erfinder: **Zuber, Herbert, Hofäckerring 11, D-7814 Oberrimsingen (DE)**
Erfinder: **Biebl, Ulrich, Bleilestrasse 4, D-7809 Winden 2 (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

(54) Monolithisch integrierte Schaltung mit einem I2L-Schaltungsteil und einem Analog-Schaltungsteil.

(57) Monolithisch integrierte Schaltung mit einem $I^2$ L-Schaltungsteil, enthaltend mindestens einen $I^2$ L-Transistor, und einen Analog-Schaltungsteil der mindestens einen Analogtransistor mit einer an der Halbleiteroberfläche liegenden Emitterzone aufweist. Es wird das Problem behandelt, bei solchen monolithisch integrierten Schaltungen, deren Zonen innerhalb zweier übereinander auf einem halbleitenden Substrat des einen Leitungstyps aufgebrachten Epitaxschichten (3) (4) des anderen Leitungstyps angeordnet sind, bei vorgegebenen Dicken und Dotierungskonzentrationen der Epitaxschichten und daher vorgegebener Durchbruchspannung $U_{CE0}$ des Analogtransistors erhöhte Stromverstärkungswerte $\beta$ im $I^2$ L-Transistor zu erhalten. Dieses Problem wird dadurch gelöst, daß eine unter der Basiszone (1) des $I^2$ L-Transistors an der Grenzfläche der beiden Epitaxschichten angeordnete vergrabene Schicht (5) Dotierungen erhält, die langsamer diffundieren als die in der darüberliegenden Basiszone (1) und der Kollektorzonen (7) vorhandenen und daß ein bestimmtes Dickenverhältnis der Epitaxschichten mit entsprechend daraus sich ergebender Verengung der Basiszone (1) des $I^2$ L-Transistors gewählt wird.

A. Wirth et al 5-1-1
Go/bk - Fl 989
26. November 1979

BEZEICHNUNG GEÄNDERT,
siehe Titelseite

## Monolithisch integrierte Schaltung

Die Erfindung beschäftigt sich mit einer monolithisch integrierten Schaltung, die mindestens einen einen Analogtransistor enthaltenden Analogschaltungsteil und mindestens einen einen $I^2L$-Transistor enthaltenden $I^2L$-Schaltungsteil enthält. Bei einer solchen integrierten Schaltung besteht häufig das aus der Zeitschrift "Valvo-Berichte", Band XVIII, Heft 1/2, (April 1974), S. 215 bis 216, bekannte Problem, im Analogschaltungsteil hohe Versorgungsspannungen verarbeiten zu können und außerdem ausreichend große Stromverstärkungswerte ß der mitintegrierten $I^2L$-Transistoren zu erhalten. Hohe Versorgungsspannungen im Analogschaltungsteil erfordern nämlich Epitaxschichten relativ hohen spezifischen Widerstands ($> 2 \Omega \cdot cm$) und relativ großer Dicke ($> 10 \mu m$).

Zur besseren Erläuterung der Erfindung wird im folgenden vereinfachend die Erfindung im Hinblick auf eine monolithisch integrierte Schaltung mit lediglich einem Analogtransistor und nur einem $I^2L$-Transistor beschrieben. Die in der Praxis realisierten monolithisch integrierten Schaltungen der von der Erfindung betroffenen Art weisen natürlich eine Mehrzahl von $I^2L$-Transistoren im $I^2L$-Schaltungsteil und eine Mehrzahl von Analogtransistoren im Analogschaltungsteil auf.

Die Erfindung betrifft somit eine monolithisch integrierte Schaltung gemäß dem Gattungsbegriff des Anspruchs 1, wie sie im übrigen aus "1978 IEEE International Solid-State Circuits Conference, Digest of Technical Papers" (Februar 78)

0016860

A. Wirth et al 5-1-1                                      Fl 989

Seiten 44 bis 45, bekannt ist.

Der Erfindung liegt die Aufgabe zugrunde, bei der bekannten monolithisch integrierten Schaltung bei vorgegebenen Dicken und Dotierungskonzentrationen der Epitaxschichten und daher vorgegebener Durchbruchspannung $U_{CEo}$ des Analogtransistors die Stromverstärkungswerte ß im $I^2L$-Transistor noch weiter erhöhen zu können.

Diese Aufgabe wird erfindungsgemäß durch die im kennzeichnenden Teil des Anspruchs 1 angegebene Ausbildung gelöst.

Die Erfindung, ihre Vorteile und eine Weiterbildung werden im folgenden anhand der Zeichnung erläutert, deren

Fig. 1    schematisch eine Ausschnittansicht im Schnitt senkrecht zur Oberfläche eines plattenförmigen Halbleiterkörpers zeigt, welche ein Zwischenstadium bei der Herstellung einer monolithisch integrierten Schaltung nach der Erfindung gemäß dem Ausführungsbeispiel veranschaulicht, deren

Fig. 2    die entsprechende Querschnittansicht nach der Diffusion sämtlicher Zonen vor dem Anbringen der Kontakte bedeutet und deren

Fig. 3    zur Veranschaulichung einer Weiterbildung der monolithisch integrierten Schaltung nach der Erfindung dient.

Bei dem Ausführungsbeispiel soll ein $I^2L$-Vierfachkollektortransistor realisiert werden, der für jeden Kollektor einen ß-Wert von wesentlich größer als 5 (gemessen bei 10 µA

A. Wirth et al 5-1-1                              Fl 989

Kollektorstrom) und ein $U_{CEo}$ von größer als 0,9 V aufweist. Zugleich sollen im Analogschaltungsteil Analogtransistoren realisiert werden, welche reproduzierbar
$U_{CEo}$-Werte von größer als 60 V aufweisen.

Zur Herstellung der monolithisch integrierten Schaltung
nach der Erfindung wird auf ein p-dotiertes Silicium-
Substrat mit einem spezifischen Widerstand zwischen 1
und 3 $\Omega$ ·cm zunächst die "vergrabene Schicht" 10 unter
Anwendung des bekannten Planardiffusionsprozesses für den
Analogtransistor B im Analogschaltungsteil eingebracht,
welche lediglich zur Erniedrigung des Kollektorwiderstandes dient. Auf dieselbe Oberflächenseite wird anschließend die untere erste Epitaxschiht 3 in einer Dicke
von 10 µm mit einem spezifischen Widerstand von $\varrho$ = 5 $\Omega$·cm
aufgebracht, in die zur Herstellung der Zwischenschicht 5
eine entsprechend dimensionierte Planardiffusion unter
Verwendung von Antimon oder Arsen bei 1200°C über einer
Stunde nach Anwendung eines Aufbringungsprozesses in
üblicher Weise erfolgt, so daß ein Schichtwiderstand von
30 $\Omega$/□ erhalten wird.

Grundsätzlich sollte die herzustellende Zwischenschicht 3
mindestens einen Zehnerpotenz höher dotiert sein als die
bereits aufgebrachte Epitaxschicht 3 und die anschließend
aufzubringende Epitaxschicht 4, wobei die Zwischenschicht
in einer bestimmten Ausdehnung, welche durch die Diffusion
der Dotierung in die beiden Epitaxschichten 3 und 4 gegeben ist, sich vergrößert.

Anschließend erfolgt in bekannter Weise die Isolationsdiffusion mit Bor bei 1220°C über 7 Stunden nach einem
üblichen Bor-Aufbringungsprozeß. Auch dabei dehnt sich die
Zwischenschicht 5 aus, so daß eine Diffusionsstruktur

A. Wirth et al 5-1-1                          Fl 989

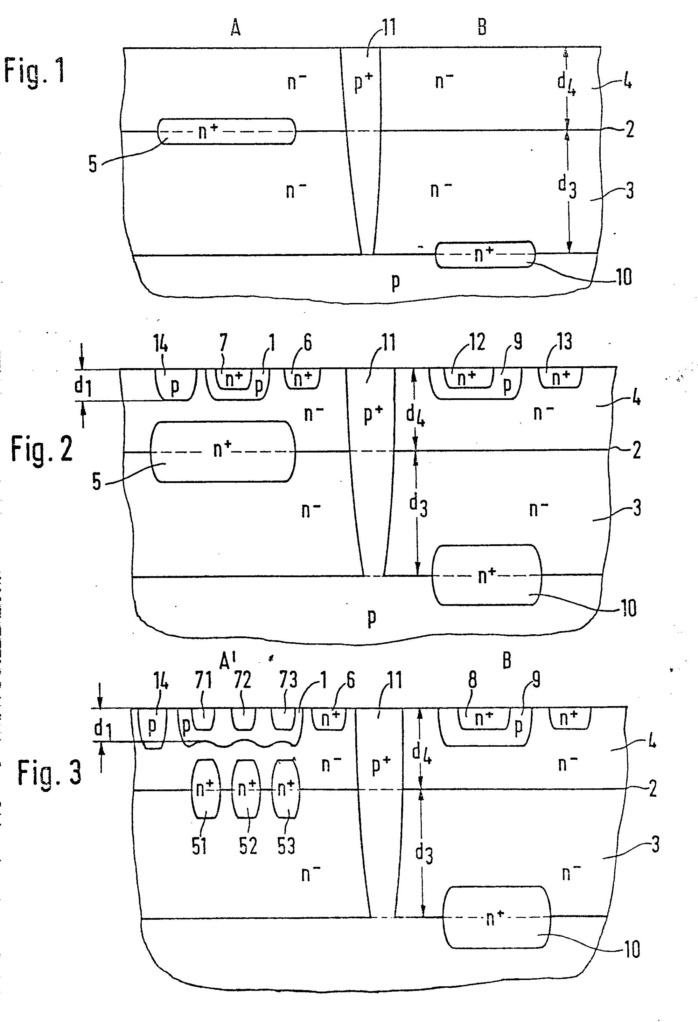

entsprechend der Fig. 1 mit der Diffusionszone 11 erhalten wird, welche den Analogschaltungsteil vom $I^2L$-Schaltungsteil trennt.

Anschließend erfolgt nach einem üblichen Bor-Aufbringungsprozeß der Basisdiffusionsprozeß bei 1200°C über 35 Minuten, so daß ein Flächenwiderstand von 150 $\Omega$ / $\square$ erhalten wird.

Schließlich wird nach üblicher Aufbringung von Phosphor und einer Vordiffusion unter Anwendung des bekannten Planardiffusionsverfahrens die sogenannte Emitterdiffusion bei 1000°C über 100 Minuten Diffusionsdauer derart geführt, daß ein Flächenwiderstand von 6,5 $\Omega$ / $\square$ erhalten wird. Bei diesem Emitterdiffusionsprozeß werden gleichzeitig die Emitterzone 12 und die Kollektorkontaktierungszone 13 des Analogtransistors B sowie die Kollektorzone 7 und die Emitterkontaktierungszone 6 des $I^2L$-Transistors A erzeugt. Damit wird eine Struktur gemäß der Fig. 2 erhalten.

Die Basiszoneneindringtiefe d9 des Analogtransistors B beträgt 2,9 μm, während die Basiszoneneindringtiefe d1 des $I^2L$-Transistors A lediglich 2,7 μm ist. Dieser Unterschied beruht auf dem Effekt der Ausdiffusion der Arsenoder Antimon-Atome aus der Zwischenschicht 5.

Zieht man von den oben genannten Basiszoneneindringtiefen noch die Eindringtiefe der Emitterzone 8 bzw. die Eindringtiefe der Kollektorzone 7 mit 2 μm ab, so ergibt sich unter der Emitterzone 8 im Analogtransistor B eine Dicke der Basiszone 9 von 0,9 μm und eine Dicke der Basiszone 1 unter der Kollektorzone 7 von 0,7 μm.

Man kann den oben geschilderten Stauchungsprozeß der Basiszone 1 des $I^2L$-Transistors durch die aus der Zwischenschicht 5 ausdiffundierenden Dotierungen praktisch beliebig weit treiben. Die obere Stauchungsgrenze ergibt sich jedoch durch die Bedingung, daß der $I^2L$-Transistor A eine Kollektordurchbruchspannung von $U_{CEo}$ von mehr als 0,9 V aufweisen muß.

Die Fig. 3 veranschaulicht an einer den Fig. 1 und 2 entsprechenden Querschnittsansicht eine Weiterbildung der monolithisch integrierten Schaltung nach der Erfindung. Bei dieser Weiterbildung ist die Zwischenschicht in Teilschichten 51, 52 und 53 unterhalb der Kollektorzonen 71, 72 und 73 eines $I^2L$-Multikollektortransistors A' aufgeteilt. Da unterhalb des Zwischenraums zwischen den Kollektoren 71, 72 und 73 die Basiszone 1 mangels der dort nicht bzw. weniger vorhandenen Dotierungsatome der Teilschichten 51, 52 und 53 nicht oder kaum gestaucht wird, ergibt sich für die Basiszone 1 eine Rippenstruktur mit rippenförmigen Basiszonenteilen im Raum zwischen den Kollektoren 71, 72 und 73. Dies hat den Vorteil eines verringerten Basisbahnwiderstands, so daß auch dem dem Basiskontakt am weitesten entfernt liegenden Kollektor ein ausreichender Kollektorstrom entnehmbar ist. Ein weiterer Vorteil dieser Rippenstruktur gemäß der Fig. 3 besteht hinsichtlich der Emitterergiebigkeit der hochdotierten Teilschichten 51, 52 und 53. Da die Basiszone 1 nämlich im wesentlichen nur unterhalb der Kollektorzonen 71, 72 und 73 verengt ist, ergibt sich dort eine erhöhte Emitterergiebigkeit, während die Emitterergiebigkeit in den Bereichen der Basiszone 1 zwischen Kollektoren 71, 72 und 73 erheblich vermindert ist.

0016860

A. Wirth et al 5-1-1                                    Fl 989

Eine monolithisch integrierte Schaltung gemäß der Weiterbildung nach der Fig. 3 kann in gleicher Weise hergestellt werden wie die monolithisch integrierte Schaltung gemäß den Fig. 1 und 2.

Fig. 3 zeigt übrigens, daß die Injektorzone 14 des $I^2L$-Transistors, welche gleichzeitig mit den Basiszonen 1 und 9 diffundiert wird, nicht gestaucht ist, da unterhalb dieser Injektorzone 14 die Zwischenschicht 5 bzw. eine Teilschicht derselben fehlt. Dieser Stauchungseffekt der Injektorzone 14 ist dagegen bei dem Ausführungsbeispiel gemäß den Fig. 1 und 2 festzustellen, da dort die Zwischenschicht 5 sich auch unterhalb der Injektorzone 14 erstreckt.

A. Wirth et al 5-1-1

Fl 989
Go/bk
26. November 1979

## Patentansprüche

1. Monolithisch integrierte Schaltung mit einem Analogtransistor und einem I²L-Transistor, deren Zonen innerhalb zweier übereinander auf einem halbleitenden Substrat des einen Leitungstyps aufgebrachten Epitax-schichten des anderen Leitungstyps angeordnet sind, wobei unter der Basiszone des I²L-Transistors an der Grenzfläche der beiden Epitaxschichten eine höher als die Epitaxschichten dotierte Zwischenschicht vom Leitungstyp der Epitaxschichten angeordnet ist, dadurch gekennzeichnet,

daß die Zwischenschicht (5; 51, 52, 53) Dotierungen enthält, die langsamer diffundieren als die in der Basiszone (1) und der Kollektorzone (7) bzw. in den Kollektorzonen (71, 72, 73) des I²L-Transistors vorhandenen Dotierungen, und

daß die Dicken (d3, d4) der Epitaxschicht (3, 4) derart bemessen sind, daß nach Durchführung sämtlicher nach dem Aufbringen der Epitaxschichten (3, 4) folgender Diffusionsprozesse die unter der Kollektorzone (7) bzw. den Kollektorzonen (71, 72, 73) erhaltene Basiszonendicken (d1) des I²L-Transistors (A) gegenüber der unter der Emitterzone (8) erhaltenen Basiszonendicke (d9) des Analogtransistors (B) um mindestens 20% vermindert ist.

2. Monolithisch integrierte Schaltung nach Anspruch 1, dadurch gekennzeichnet, daß die Zwischenschicht (5) um mindestens eine Zehnerpotenz höher dotiert ist als

A. Wirth et al 5-1-1 Fl 989

die Epitaxschichten (3, 4).

3. Monolithisch integrierte Schaltung nach Anspruch 1 oder 2, dadurch gekennzeichnet, daß zwischen der Zwischenschicht (5) und einer Kontaktierungszone (6) in der freien Oberfläche der oberen Epitaxschicht (4) gleichen Leitungstyps ein Abstand besteht.

4. Monolithisch integrierte Schaltung nach einem der Ansprüche 1 bis 3, dadurch gekennzeichnet, daß die Zwischenschicht (5) in Teilschichten (51, 52, 53) unterhalb der Kollektorzonen (71, 72, 73) eines $I^2L$-Multikollektortransistors (A') aufgeteilt ist.

5. Monolithisch integrierte Schaltung nach einem der Ansprüche 1 bis 4, dadurch gekennzeichnet, daß bei Verwendung von Silicium als Material der Epitaxschichten (3, 4) die Zwischenschicht (5; 51, 52, 53) mit Arsen und/oder Antimon dotiert ist.

Fig. 1

Fig. 2

Fig. 3

Europäisches
Patentamt

EUROPÄISCHER RECHERCHENBERICHT

0016860

Nummer der Anmeldung

EP 79 10 4830

## EINSCHLÄGIGE DOKUMENTE

| Kategorie | Kennzeichnung des Dokuments mit Angabe, soweit erforderlich, der maßgeblichen Teile | betrifft Anspruch | KLASSIFIKATION DER ANMELDUNG (Int.Cl. 3) |
|---|---|---|---|
| | PATENT ABSTRACTS OF JAPAN, Band 2, Heft 79, 23. Juni 1978, Seite 3304 E 78 & JP - A - 53 44186 | 1,2,5 | H 01 L 27/02 21/74// H 03 K 19/08 |
| | PATENT ABSTRACTS OF JAPAN, Band 2, Heft 37, 13. März 1978, Seite 151 E 78 & JP - A - 53 3781 | 1-3 | |
| | PATENT ABSTRACTS OF JAPAN, Band 2, Heft 90, 22. Juli 1978, Seite 4184 E 78 & JP - A - 53 54983 | 1,2 | **RECHERCHIERTE SACHGEBIETE (Int. Cl. 3)** H 01 L 27/02 21/74 |
| | PATENT ABSTRACTS OF JAPAN, Band 2, Heft 141, 22. November 1978, Seite 8854 E 78 & JP - A - 53 108 783 | 1,2 | |
| | FR - A - 2 339 254 (ITT INDUSTRIES) * Figuren; Ansprüche * & DE - A - 2 602 395 | 1,4 | |
| | DE - A - 2 800 240 (RCA) * Figuren; Ansprüche * | ,2 | **KATEGORIE DER GENANNTEN DOKUMENTE** X: von besonderer Bedeutung A: technologischer Hintergrund O: nichtschriftliche Offenbarung P: Zwischenliteratur T: der Erfindung zugrunde liegende Theorien oder Grundsätze E: kollidierende Anmeldung D: in der Anmeldung angeführtes Dokument L: aus andern Gründen angeführtes Dokument &: Mitglied der gleichen Patent- familie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 29-02-1980 | CARDON |

EPA form 1503.1 06.78